# FASCICULE DE BREVET EUROPEEN

(11) **EP 0 627 798 B1**
(45) Date de publication et mention de la délivrance du brevet: **06.08.1997**
(21) Numéro de dépôt: 94401188.1
(22) Date de dépôt: 30.05.1994
(51) Int. Cl.: H01S 3/103, H01S 3/025, H01L 27/15, G02F 1/025, H04B 10/00

(54) **Composant intégré monolithique laser-modulateur à structure multi-puits quantiques**
Monolithisch integrierte Laser-Modulator-Anordnung mit Multiquantumwell-Struktur
Monolithically integrated laser-modulator with multiquantum well structure

(30) Priorité: 02.06.1993 FR 9306565
(43) Date de publication de la demande: 07.12.1994
(73) Titulaire: FRANCE TELECOM, 75015 Paris (FR)
(72) Inventeur: Ramdane, Abderrahim, F-92330 Sceaux (FR); Devaux, Fabrice, F-75014 Paris (FR); Ougazzaden, Abdallah, F-92260 Fontenay aux Roses (FR)
(74) Mandataire: Signore, Robert

(56) Documents cités:
- EP-A- 0 531 214
- JP-A- 3 120 777
- JP-A- 3 291 617
- ELECTRONICS LETTERS., vol.28, no.12, 4 Juin 1992, ENAGE GB pages 1157 - 1158, XP000304649 M.AOKI ET AL. 'High-speed (10 Gbit/s ) and low-drive-voltage (1 v peak to peak ) InGaAs/InGaAsP MQW electroabsorption-modulator integrated DFB laser with semi-insulated buried heterostructure'
- PATENT ABSTRACTS OF JAPAN vol. 10, no. 376 (E-464) (2433) 13 Décembre 1986 & JP-A-61 168 980
- APPLIED PHYSICS LETTERS., vol.64, no.8, 21 Février 1994, NEW YORK US pages 954 - 956, XP000425902 F.DEVAUX ET AL. 'Zero-loss multiple-quantum-well electroasorption modulator with very low chirp'
- PATENT ABSTRACTS OF JAPAN vol. 10, no. 376 (E-464) (2433) 13 Décembre 1986
- JP-A-61 168 980

## Description

L'invention a pour objet un composant intégré monolithique laser-modulateur en matériau semi-conducteur utilisant une même structure à multi-puits quantiques. Cette structure est utilisable principalement dans le domaine des télécommunications par fibres optiques, par exemple pour des liaisons numériques à haut débit et à longue distance ainsi que dans le domaine des ordinateurs tout optique.

L'invention utilise la technique de modulation d'intensité d'un faisceau lumineux qui consiste en la variation d'absorption optique d'un matériau sous l'effet d'un champ électrique. Ce dernier est appliqué par exemple au moyen d'une diode PIN polarisée en inverse dans laquelle la région intrinsèque (non intentionnellement dopée) contient le matériau électro-absorbant (ou actif).

L'intégration monolithique d'un laser à semi-conducteur et d'un modulateur électro-optique de puissance du flux lumineux émis par le laser fait l'objet de nombreux travaux du fait de son importance en opto-électronique. Cette intégration est un axe de recherche et de développement stratégique notamment dans le domaine des télécommunications par fibres optiques à 1,55 µm pour le transfert d'informations à haut débit et à longue distance.

Le composant intégré correspondant présente une grande bande passante et surtout pas d'élargissement spectral, avantages qui sont liés à une modulation externe de la diode laser émettrice (voir à cet effet le document (1)- (F. Koyama and K. Iga, "Frequency chirping in external modulators", Journal of Lightwave Technology, vol. 6, n° 1, 1988, p. 87-93).

La technologie d'intégration doit cependant rester aussi simple que possible et surtout préserver les propriétés des deux éléments opto-électroniques (laser, modulateur).

Les composants intégrés (laser-modulateur) sont formés de couches épitaxiées semi-conductrices similaires, formant des diodes PIN que l'on polarise en direct pour le laser et en inverse pour le modulateur.

L'intégration d'un laser et d'un modulateur fonctionnant autour de 1,55µm est décrite dans le document (2) FR-A-2 681 191 utilisant l'effet "Wannier-Stark" utilisant un "super-réseau très couplé". On rappelle, à cet égard, qu'un super réseau ("super-lattice" en terminologie anglo-saxonne ou SL en abrégé) très couplé est une succession de puits et de barrières de potentiel (généralement 20 à 30) dans laquelle les épaisseurs respectives des puits et des barrières sont très faibles, de sorte que les puits sont très couplés les uns avec les autres par effet tunnel résonnant.

On distingue cette structure de celle dite à multi-puits quantiques ("multiple quantum well" en terminologie anglo-saxonne ou MQW en abrégé) qui est aussi une succession de puits et de barrières de potentiel (généralement inférieure à 20) dans laquelle l'épaisseur des barrières est suffisamment grande pour que les puits ne soient pas couplés les uns avec les autres.

D'autres composants intégrés monolithiques fonctionnant à 1,55 µm ont été décrites dans le document (3) de M. Suzuki et al, "λ/4-shifted DFB laser/electroabsorption modulator integrated light source for multigigabit transmission", IEEE Transactions on Lightwave Technology, vol. 10, n° 1, 1992, p. 90-95, utilisant un modulateur à effet Franz-Keldysh et dans le document (4) de I. Kotaka et al. "A low-drive-voltage, high-speed monolithic multiple-quantum-well modulator/DFB laser light source", IEEE Photonics Technology Letters, vol. 5, n° 1, 1993, p. 61-63, utilisant un modulateur à effet Stark confiné.

Les modulateurs intégrés des documents (3) et (4) fonctionnent à des longueurs d'onde supérieures à celles du bord de bande d'absorption de la couche active du modulateur, du fait que l'application d'un champ électrique dans le matériau électro-absorbant induit un décalage du front d'absorption vers les grandes longueurs d'onde, c'est-à-dire vers les basses énergies, (décalage appelé "red-shift" en terminologie anglo-saxonne). Cela signifie que l'application d'un champ électrique en polarisation inverse ne peut qu'augmenter l'absorption d'un matériau initialement transparent en utilisant ces effets. Ainsi, le matériau de la couche active du modulateur doit être suffisamment transparent en l'absence de champ électrique.

En revanche, dans le cas du laser, l'émission stimulée se produit à une énergie sensiblement égale à celle de la bande interdite de la couche active du laser, en particulier pour dés niveaux d'injection faibles de porteurs.

C'est pour ces raisons que pour des composants monolithiques laser-modulateur fonctionnant à 1,55µm, sur substrat InP, on utilisait jusqu'à présent des couches actives différentes et donc des bandes d'énergie interdites différentes pour le laser et le modulateur.

Ainsi, dans les documents (3) et (4) on utilisait deux étapes d'épitaxie pour faire croître séparément les deux structures, avec un décalage en longueur d'onde optimal.

Une autre approche pour réaliser séparément les deux structures est décrite dans le document (5) de V. Hornung et al, "Simple approach for monolithic integration of DFB laser and passive waveguide", Electronics Letters, vol. n° 18, 1991, p. 1683-1685. Dans ce document, on utilise une seule épitaxie pour les deux composés sur un substrat préalablement gravé avec optimisation séparée des deux structures.

Plus récemment, on a envisagé l'intégration du laser et du modulateur à l'aide d'une seule épitaxie sélective avec des masques de silice, en utilisant une structure à puits quantiques du type InGaAs/InGaAsP comme décrit dans le document (6) de M. Aoki et al, "High-speed (10Gbits/s and low-drive-voltage (1V peak to peak) InGaAs/InGaAsP MQW electroabsorption-modulator integrated DFB laser with semi-insulating buried heterostructure", Electronics Letters, vol. 28 n° 12, 1992, p. 1157-1158.

Dans ce cas, aucune croissance ne s'effectue sur les zones masquées à l'inverse des zones non masquées, et on obtient ainsi un décalage en longueur d'onde entre les zones masquées et non masquées. Ce décalage est fonction de la forme des masques utilisés pour la croissance sélective et peut être contrôlée de façon précise.

L'utilisation de deux structures différentes pour le laser et le modulateur présente un certain nombre d'inconvénients, notamment en ce qui concerne le processus de fabrication de ces composants.

En effet les solutions nécessitant deux épitaxies (références 3 et 4) ont l'inconvénient d'être lourdes et délicates aussi bien en ce qui concerne l'épitaxie qu'en ce qui concerne la technologie (étapes technologiques sur substrat non plan). Il est ainsi difficile de conserver les performances des deux composants lors de l'intégration.

Par ailleurs, l'utilisation d'une seule épitaxie sur substrat gravé (référence 5) nécessite également une bonne optimisation des paramètres de la croissance. Cette solution présente en outre les inconvénients d'une technologie sur des échantillons non plans.

Ainsi, les solutions "planaires" auraient, à l'inverse, l'avantage d'une technologie similaire à celle utilisée pour des composants discrets, donc plus simple et avec un rendement meilleur.

Dans le cas d'une seule épitaxie sélective plane, une optimisation aussi bien du type de masque et de sa forme que de la préparation de la surface avant épitaxie est nécessaire. La mise en oeuvre de cette méthode reste alors assez délicate. De plus, le changement de longueur d'onde obtenu avec cette technique est graduel et s'étend sur une zone de transition trop importante pouvant induire des pertes d'absorption.

L'utilisation d'une seule épitaxie plane de la même couche active utilisant des puits quantiques sur un substrat en GaAs pour un fonctionnement à 0,8µm a été décrite dans le document (7) de S. Tarucha and H. Okamoto, "Monolithic intégration of a laser diode and an optical waveguide modulateur having a GaAs/AlGaAs quantum well double heterostructure", Applied Physics Letters 48, (1) 1986, p 1-3 et dans le document (8) de W.X. Zou et al, "Low-threshold InGaAs/GaAs/AlGaAs quantum-well laser with an intracavity optical modulator by impurity-induced disordering", Applied Physics Letters 62, (6) 1993, p. 556-558, ainsi que dans le document (9) Patent Abstracts of Japan, vol. 16, n°125 (E-1331) March 30, 1992 (JP-A-3 291 617).

Cette solution semble a priori difficile à comprendre étant donné que la longueur d'onde optimale de fonctionnement du modulateur devrait être plus courte que la longueur d'onde d'émission du laser. Aussi, pour expliquer ce comportement inhabituel, on a invoqué dans le document (7) l'effet de "renormalisation du gap", qui entraîne une diminution de la largeur de bande effective de la couche active d'un laser sous polarisation directe, diminution liée à l'augmentation de la densité de porteurs injectés dans la couche active.

Dans la référence (8), on décrit des puits quantiques contraints en InGaAS et la fabrication de lasers à l'aide d'une technique d'interdiffusion (variation de la largeur de bande interdite induite par diffusion de silicium). L'utilisation dans ce cas de puits contraints a pour avantage de réduire, de façon significative, les courants d'injection de porteurs pour atteindre la transparence, car les courants de seuil du laser sont diminués en comparaison des puits quantiques classiques en GaAs comme dans la référence (7).

L'inconvénient des composés sur GaAs est leur gamme de fonctionnement très différente de celle des structures sur InP.

Par ailleurs, les références (7) et (8) utilisent un laser du type Fabry-Pérot avec un modulateur "intracavité" formant la partie passive de la cavité qui, sur pompage optique induit par la partie laser, devient transparente à l'aide d'un flux de photons relativement faible. Dans ce type de laser, les pertes d'absorption du modulateur à l'état passant, c'est-à-dire en l'absence de champ électrique appliqué, restent très importante. En outre, la raie d'émission est généralement large. Mais dans le document (9), il est fait usage d'un réseau de diffraction.

La solution de fabrication préconisée dans les références (7) et (8) demeure en principe idéale, car elle repose sur une seule épitaxie plane de la même couche active pour le laser et le modulateur.

Ce principe de monoépitaxie plane de la couche active est aussi utilisé dans le document (2) . Cependant, dans ce cas, les modulateurs à effet Wannier-Stark sont réalisés dans le système InGaAlAs/InP. Ces matériaux présentent l'inconvénient de contenir de l'aluminium, élément difficile à travailler, et leur technologie n'est pas aussi développée que celle des composants à base de phosphore (InGaAsP).

L'utilisation d'une seule et même couche pour le laser et le modulateur est également enseignée dans le document (10) : Patent Abstract of Japan, vol. 15, n°323 (E-1101), August 16, 1991 (JP-A-3 120 777). Mais, dans cette technique, la couche unique active ou absorbante n'est pas constituée par une structure à multipuits quantiques. Il n'y a donc pas de phénomène de décalage de longueur d'onde lié à l'effet STARK, comme on en trouve dans les multipuits quantiques.

L'invention, selon la revendication 1, a trait encore à un composant intégré où une même couche MQW est utilisée pour réaliser la couche active du laser et la couche absorbante du modulateur. De plus, le composant de l'invention utilise un réseau de Bragg périodique pour réaliser un laser DFB (pour "Distributed FeedBack). Selon l'invention, on donne au pas de ce réseau une valeur appropriée pour que la longueur d'onde d'émission du laser se situe à une valeur légèrement supérieure à la longueur d'onde correspondant au maximum du pic de gain du laser et donc à une longueur d'onde légèrement supérieure à celle correspondant au pic d'absorption du modulateur. Par ailleurs, le modulateur étant lui aussi du type multipuits quantiques (MQW), il travaille par effet STARK confiné.

Selon l'invention, les puits peuvent être contraints ou non.

L'utilisation d'une même couche active et absorbante est aussi possible du fait que les lasers à MQW et en particulier à MQW contraint, (ce qui est notamment le cas pour des structures en InGaAsP et InGaAs sur de l'InP) présentent une courbe de gain suffisamment étendue pour pouvoir ajuster, grâce au réseau de Bragg, entrant dans la constitution du laser, la longueur d'onde d'émission du laser à la valeur au-delà du maximum de gain (valeur optimale de modulation de la couche électro-absorbante du modulateur).

La possibilité de réaliser des lasers DFB émettant sur une grande plage de longueur d'onde et à des longueurs d'onde déterminées par le pas d'un réseau de Bragg a été démontrée pour des applications de multiplexage en longueur d'onde dans le document (11) de C.E. Zah et al, "1,5 µm compressive-strained multiquantum-well 20-wavelength distributed feedback laser arrays" - Electronics Letters, vol. 28, n°9, 1992, p. 824-826. Dans cette référence, vingt longueurs d'onde différentes ont pu être mesurées sur une plage de 131 nm autour de 1,5 µm.

Par ailleurs, il est connu du document (12) de F. Devaux et al., "In GaAsP/InGaAsP multiple-quantum well modulator with improved saturation intensity and bandwidth over 20 GHz", IEEE Photonics Technology Letters, vol. 4, 1992, p. 720-723, qu'un modulateur à structure MQW avec des couches barrières et des puits quantiques en InGaAsP présente de bonnes caractéristiques.

D'autres caractéristiques et avantages de l'invention ressortiront mieux de la description qui va suivre, donnée à titre illustratif et non limitatif, en référence aux figures annexées sur lesquelles :
- la figure 1 illustre, schématiquement, en coupe transversale, un composant monolithique conforme à l'invention ;
- la figure 2 donne le gain en cm⁻¹, du laser en fonction de la longueur d'onde λ d'émission, en µm, pour un laser utilisant une couche active MQW à cinq puits quantiques contraints ;
- la figure 3 donne le spectre d'absorption excitonique A, en unité arbitraire, en fonction de la longueur d'onde λ, en µm, pour la même structure à puits quantiques que celle de la figure 2 ;
- la figure 4 donne la puissance P d'émission laser, en mW, en fonction du courant I, en mA, appliqué, au composant de l'invention de même structure MQW que celle de la figure 2 ;
- la figure 5 donne la courbe de transmission T en décibel par unité de longueur d'un composant de l'invention en fonction de la tension de polarisation Vi, en volts, et pour différentes longueurs d'onde.

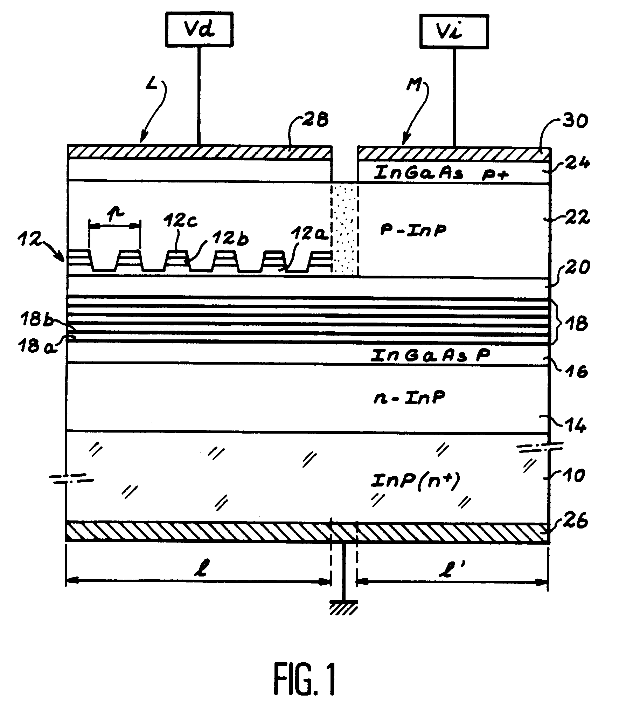

En référence à la figure 1, le composant monolithique conforme à l'invention comprend un laser L et un modulateur M réalisés sur un même substrat 10 d'InP dopé N⁺, à 5.10¹⁸ ions/cm³ et de surface plane. Sur ce substrat ont été épitaxiées des couches semi-conductrices identiques pour le laser L et le modulateur M à l'exception de la présence d'un réseau de Bragg périodique 12 pour le laser. Les couches semi-conductrices sont épitaxiées selon la technique MOCVD (dépôt chimique en phase vapeur utilisant des organométalliques).

On trouve, dans l'ordre, une couche tampon 14 d'InP dopé N typiquement à 2.10¹⁸ ions/cm³ de 500 nm d'épaisseur ; une couche de confinement optique inférieure 16 en InGaAsP non dopé de 100 nm d'épaisseur ; une couche active 18 de 150 nm d'épaisseur comportant de 5 à 12 puits quantiques 18a séparés par des barrières de potentiel 18b, réalisée en InGaAsP non dopé ; une couche de confinement optique supérieur 20 aussi en InGaAsP non dopé de 100nm d'épaisseur ; le réseau de Bragg 12 conservé uniquement du côté du laser L ; une couche 22 en InP dopé P complétant ainsi la diode PIN du laser et du modulateur et assurant l'enterrement de la structure active, la couche 22 étant dopée à 10¹⁸ ions/cm³ et ayant une épaisseur de 1,8µm et enfin une couche de contact électrique 24 en InGaAs dopée P+ à 10¹⁹ ions/cm³ de 200 nm d'épaisseur.

La composition en In et P des couches de confinement 16 et 20 doit être telle que leur indice optique soit supérieur à celui des couches 14 et 22 de la diode, mais inférieur à celui des puits quantiques 18a. Par ailleurs, la composition en In et P des couches barrières 18b de la structure MQW doit être telle que la bande d'énergie interdite de ces barrières soit supérieure à celle des puits quantiques 18a.

En respectant ce même principe d'indice et de bande interdite, il est possible de remplacer le matériau quaternaire InGaAsP par le matériau ternaire InGaAs.

A titre d'exemple, les couches 16 et 20 ont une composition respectivement en In et P de 0,79 et 0,44 ; les couches barrières 18b ont une composition en In et P respectivement de 0,79 et 0,44 ; et les puits quantiques 18a ont une composition en In et P respectivement de 0,70et 0,13.

Le nombre de puits est par exemple égal à 10 afin d'améliorer les performances de modulation sans amoindrir celles du laser ; leur épaisseur est de 10 nm et celle des barrières de 5 nm.

Le réseau de Bragg périodique 12 est constitué d'un matériau tricouche InP/InGaAsP/InP non dopé gravé pour former une structure périodique dont le pas p fixe la longueur d'onde d'émission du laser. Pour des couches 12a, 12c et 12b respectivement de 50, 30 et 30 nm d'épaisseur, on utilise un pas p de 240 nm de façon à obtenir un laser fonctionnant à 1,550 µm.

Le réseau de Bragg est réalisé par les techniques standard d'holographie puis attaque chimique humide, en utilisant un masque approprié sur la partie modulateur afin de ne le former que sur la partie laser.

Les couches 12, 14, 16, 18 et 20 sont formées au cours d'une première épitaxie planaire et les couches 22 et 24 au cours d'une seconde épitaxie planaire.

La structure représentée sur la figure 1 est du type BRS (Buried Ridge Striped, en terminologie anglo-saxonne) mais d'autres structures notamment du type "ridge-ridge" ou "BRS-ridge" peuvent être envisagées.

Le composant comporte en outre une couche métallique 26 formée sur la surface inférieure du substrat 10 destinée à être portée au potentiel de la masse et une couche métallique supérieure déposée sur la couche de contact 24.

Afin d'assurer l'isolation électrique du laser L et du modulateur M, une gravure des couches métallique supérieure et semi-conductrice 24 est réalisée, en formant une électrode supérieure 28 sur le laser et une électrode supérieure 30 sur le modulateur, suivie d'une implantation de protons dans la tranchée ainsi réalisée et sur toute l'épaisseur de la couche 22.

L'électrode supérieure 28 du laser L est polarisée en direct par une source de tension Vd, alors que l'électrode 30 du modulateur M est polarisée en inverse par une source de tension Vi.

On conçoit que l'épitaxie successive des différentes couches conduit à un couplage optique excellent entre le laser et le modulateur.

La largeur 1 du ruban laser est choisie de 300 à 600 µm selon les besoins. De même, la longueur 1' du ruban modulateur est choisie de 100 à 300 µm et typiquement de 300 µm.

Afin de minimiser la capacité du composant, la prise de contact électrique, côté modulateur, est obtenue à l'aide d'un plot réalisé sur du polyimide.

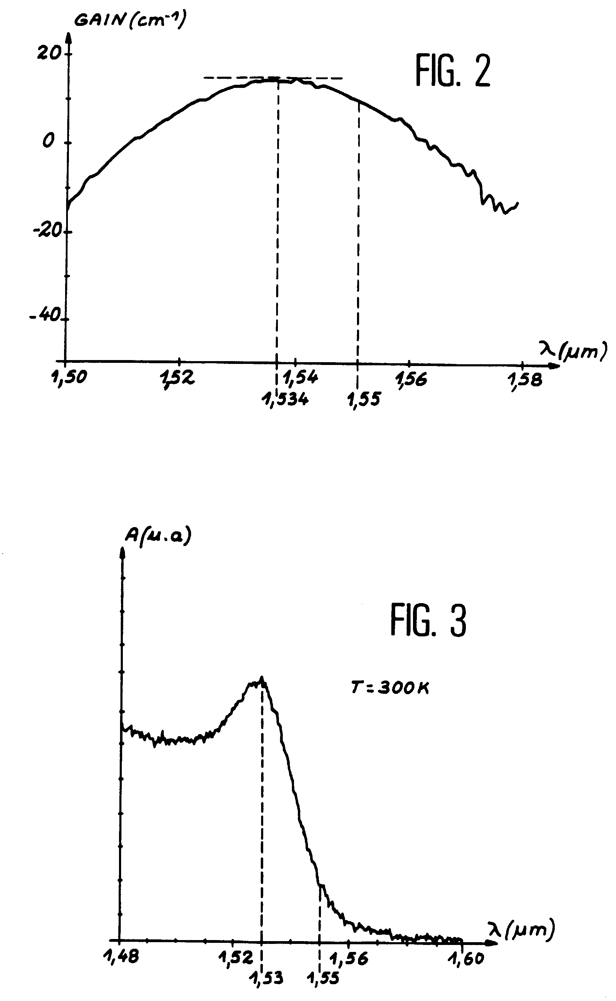

La compatibilité en longueur d'onde des deux composants va être démontrée en référence aux figures 2 à 5 suivantes utilisant une couche active à 5 puits quantiques contraints en matériau quaternaire avec une composition en In et P de 0,70 et de 0,13 pour des couches barrières de composition en In et P de 0,79 et 0,44, les puits ayant une épaisseur de 6 nm et des barrières une épaisseur de 19 nm.

Sur la figure 2, on a représenté la courbe de gain en fonction de la longueur d'onde d'émission pour un laser du type Fabry-Pérot utilisant une couche active 18 à 5 puits quantiques. Comme cela ressort de la figure 2, ce type de matériau présente un gain sur un spectre de longueur d'onde étendu. Ainsi, un effet laser peut être obtenu avec ce type de structure entre 1,52 et 1,56 µm, le maximum de gain étant à 1,534 µm.

Avec cette même couche active à 5 puits quantiques, les inventeurs ont mesuré le spectre d'absorption excitonique. Ce spectre est représenté sur la figure 3 ; il donne les variations de l'absorption, en fonction de la longueur d'onde, à une température de 300 K. On vérifie bien sur cette courbe que le pic d'absorption à 1,53 µm de la couche active coïncide avec le pic de la courbe de gain à 1,534 µm.

Aussi, pour obtenir une compatibilité optimale en longueur d'onde de modulation, on ajuste le pas du réseau de Bragg pour que le laser émette à 1,550 µm, longueur d'onde qui correspond (voir figure 3) au seuil d'absorption excitonique du modulateur. En outre, à cette longueur d'onde, l'absorption par le modulateur à l'état passant (c'est-à-dire à l'état transparent) est faible. Par ailleurs, pour le laser (voir figure 2) le gain est encore élevé et supérieur à 10 cm⁻¹.

On constate en outre sur la figure 3 que le front d'absorption excitonique est très abrupt et que la longueur d'onde de modulation optimale à 1,55 µm est très proche du seuil excitonique à 1,56 µm.

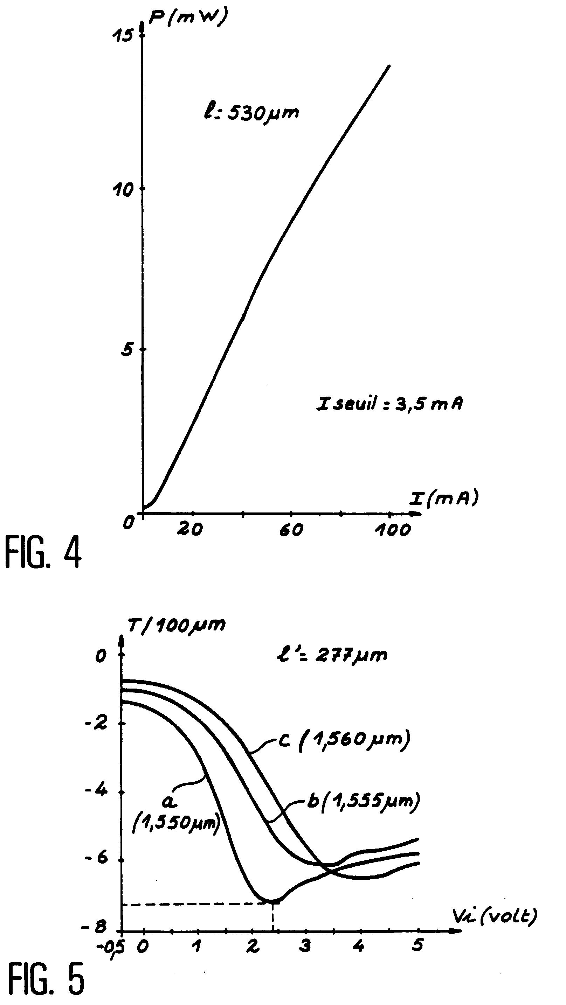

Le décalage par rapport au pic de gain ("detuning" en terminologie anglo-saxonne) induit généralement une augmentation du courant de seuil des lasers plus ou moins important selon la valeur de ce décalage, pouvant conduire à un dysfonctionnement du laser. Or, on constate d'après la figure 4 donnant les variations de la puissance laser en fonction du courant qui lui est appliqué (courant minimum nécessaire pour l'émission laser) que ce courant de seuil du laser seul est extrêmement faible puisqu'il est inférieur à 5 mA et typiquement égal à 3,5 mA pour une longueur 1 du laser de 530 µm.

On donne en outre sur la figure 5 les performances de modulation électro-optique de la même structure. Les courbes a, b et c donnent la transmission du modulateur pour respectivement, trois longueurs d'onde 1,550 µm, 1,555 µm et 1,560 µm en fonction de la tension de polarisation Vi appliquée sur le modulateur. Ces courbes sont celles d'un modulateur dont la longueur l' est de 277 µm.

On constate bien d'après ces courbes que le comportement optimal du modulateur se situe à 1,550 µm puisque la transmission minimale est inférieure à -7 dB pour une longueur de modulation de 100 µm, ce qui correspond à un taux d'extinction ou d'absorption de 17 dB pour une longueur de modulation de 277 µm, par rapport au niveau de référence correspondant à une transmission de 100 %. A l'inverse, l'absorption maximale n'est obtenue qu'à une valeur de -6 dB environ pour une modulation de 100 µm dans le cas (b) et (c).

Par ailleurs, cette absorption optimale est obtenue pour une tension Vi appliquée en inverse sur le modulateur, inférieure à 2,5 volts pour le cas a, alors que cette tension est supérieure à 3,2 volts pour les cas (b) et (c).

Ainsi, l'intégration de ces deux composants (laser et modulateur) conduit à des caractéristiques de modulation tout à fait satisfaisantes et compatibles pour une transmission optique à haut débit, de 10 Gbit/s et à longue distance. Dans ce type d'application, le laser est destiné à émettre en continu.

La description précédente n'a été donnée qu'à titre illustratif ; d'autres compositions pour constituer les différentes couches semi-conductrices ainsi que d'autres épaisseurs et d'autres taux de dopages peuvent être envisagés.

## Revendications

1. Composant électro-optique monolithique intégré, comportant :
- un substrat monocristallin d'InP (10),
- un laser (L) comportant un empilement de couches semi-conductrices épitaxiées à plusieurs puits quantiques (18a) sur ledit substrat dont une couche active (18) et un réseau de Bragg périodique (12) fixant la longueur d'onde d'émission du laser,
- un modulateur électro-optique (M) formé par ledit empilement de couches semi-conductrices épitaxiées à plusieurs puits quantiques (18a) sur ledit substrat dont ladite couche active (18), formant une couche absorbante active,
- des moyens (26, 28, Vd) pour appliquer sur l'empilement de couches laser une tension électrique directe entraînant l'émission par la couche active du laser d'un rayonnement traversant la couche absorbante active du modulateur dans le plan de cette couche,
- des moyens (26, 30) pour appliquer sur l'empilement de couches du modulateur une tension électrique inverse entraînant une absorption dudit rayonnement par ladite couche absorbante active,
ce composant étant caractérisé en ce que le pas du réseau de Bragg périodique (12) est ajusté à une valeur déterminée fixant la longueur d'onde d'émission du laser à une valeur voisine de 1,55 µm et supérieure à la longueur d'onde correspondant au maximum du pic de gain du laser et en ce que le modulateur présente, en l'absence de tension inverse appliquée à l'empilement de couches du modulateur, un pic d'absorption audit maximum du pic de gain, le modulateur n'étant alors pas absorbant pour la longueur d'onde d'émission du laser et, en présence de cette tension inverse, un pic d'absorption qui est déplacé vers une longueur d'onde plus grande que celle de la longueur d'onde d'émission du laser par effet Stark confiné, le modulateur devenant alors absorbant pour la longueur d'onde d'émission du laser.

2. Composant selon la revendication 1, caractérisé en ce que les puits sont contraints.

3. Composant selon la revendication 1 ou 2, caractérisé en ce que les couches semiconductrices sont exemptes d'aluminium.

4. Composant selon l'une quelconque des revendications 1 à 3, caractérisé en ce que la couche active et la couche absorbante sont formées de puits quantiques (18a) en InGaAsP ou InGaAs non dopé séparés par des couches barrières (18b) aussi en InGaAsP ou InGaAs non dopé, la composition en In et P étant choisie pour que les puits aient une bande d'énergie interdite inférieure à celle des couches barrières.

## Patentansprüche

1. Monolithisch integrierte elektro-optische Anordnung, umfassend:
ein monokristallines Substrat aus InP (10),
einen Laser (L), der eine Aufschichtung aus Halbleiter-Epitaxieschichten mit mehreren Quantensenken (18a) auf dem Substrat umfaßt, darunter eine aktive Schicht (18) und ein periodisches Braggnetz (12), das die Emissionswellenlänge des Lasers festlegt,
einen elektro-optischen Modulator (M), der durch die Aufschichtung der Halbleiter-Epitaxieschichten mit mehreren Quantensenken (18a) auf dem Substrat, darunter die aktive Schicht (18), gebildet ist, wodurch eine absorbierende aktive Schicht gebildet ist,
Mittel (26, 28 Vd) zum Anlegen einer elektrischen Gleichspannung an die Aufschichtung der Laserschichten, wodurch die Emission einer Strahlung durch die aktive Schicht des Lasers verursacht wird, welche durch die absorbierende aktive Schicht des Modulators in der Ebene dieser Schicht geht, Mittel (26, 30) zum Anlegen einer inversen elektrischen Spannung an die Aufschichtung der Modulatorschichten, wodurch eine Absorption dieser Strahlung durch die absorbierende aktive Schicht verursacht wird,
wobei die Anordnung dadurch gekennzeichnet ist, daß die Schrittweite des periodischen Braggnetzes (12) auf einen vorbestimmten Wert eingestellt ist, der die Emissionswellenlänge des Lasers auf einen Wert nahe von 1,55 µm und größer als die Wellenlänge entsprechend einer Maximumspitze des Lasergains festlegt, und daß der Modulator bei Abwesenheit der inversen Spannung, die an die Aufschichtung der Modulatorschichten angelegt wird, eine Absorptionsspitze bei der Maximumspitze des Gains wiedergibt, wobei der Modulator nicht-absorbierend ist für die Emissionswellenlänge des Lasers und bei Anwesenheit dieser inversen Spannung eine Absorptionsspitze wiedergibt, die in Richtung einer Wellenlänge, die größer ist als die Emissionswellenlänge des Lasers, durch den Starkeffekt verschoben ist, wodurch der Modulator für die Emissionswellenlänge des Lasers absorbiert wird.

2. Anordnung nach Anspruch 1, **dadurch gekennzeichnet, daß** die Senken eingeschränkt sind.

3. Anordnung nach Anspruch 1 oder 2, **dadurch gekennzeichnet, daß** die Halbleiterschichten frei von Aluminium sind.

4. Anordnung nach einem der vorangegangenen Ansprüche 1 bis 3, **dadurch gekennzeichnet, daß** die aktive Schicht und die absorbierende Schicht aus Quantensenken (18a) aus InGaAsP oder InGaAs gebildet sind, die nicht dotiert und durch Sperrschichten (18b) getrennt sind, die ebenfalls aus nicht dotierten InGaAsP oder InGaAs gebildet sind, wobei die Zusammensetzung von In und P in der Weise gewählt ist, daß die Senken ein verbotenes Energieband kleiner als das der Sperrschichten haben.

## Claims

1. Integrated, monolithic electrooptical component comprising an InP monocrystalline substrate (10), a laser (L) having a stack of semiconductor layers epitaxied on several quantum wells (18a) on said substrate, including an active layer (18) and a periodic Bragg grating (12) fixing the emission wavelength of the laser, an electrooptical modulator (M) formed by said stack of semiconductor layers epitaxied on several quantum wells (18a) on said substrate, said active layer (18) forming an absorbing, active layer, means (26, 28, Vd) for applying to the laser layer stack a positive voltage leading to the emission by the active layer of the laser of a radiation traversing the absorbing active layer of the modulator in the plane of said layer, means (26, 30) for applying to the stack of layers of the modulator a negative voltage leading to an absorption of said radiation by the absorbing active layer, characterized in that the spacing of the periodic Bragg grating (12) is adjusted to a given value fixing the emission wavelength of the laser to close to 155 µm and exceeding the wavelength corresponding to the maximum of the laser gain peak and in that the modulator has, in the absence of a negative voltage applied to the modulator layer stack, an absorption peak at said gain peak maximum, the modulator then not being absorbing for the laser emission wavelength and, in the presence of said reverse voltage, an absorption peak displaced towards a wavelength higher than that of the laser emission wavelength as a result of the confined Stark effect, the modulator then becoming absorbing for the laser emission wavelength.

2. Component according to claim 1, characterized in that the wells are constrained.

3. Component according to claim 1 or 2, characterized in that the semiconductor layers are aluminium-free.

4. Component according to any one of the claims 1 to 3, characterized in that the active layer and the absorbant layer are formed from undoped, InGaAsP or InGaAs quantum wells (18a) separated by undoped InGaAsP or InGaAs barrier layers (18b), the In and P composition being chosen in such a way that the wells have a forbidden energy band below that of the barrier layers.
